# FASCICULE DE BREVET EUROPEEN

(11) **EP 4 127 858 B1**
(45) Date de publication et mention de la délivrance du brevet: **10.04.2024**
(21) Numéro de dépôt: 21711254.9
(22) Date de dépôt: 15.03.2021
(51) Int. Cl.: G05G 5/05, G05G 1/04, G05G 9/047, H01H 23/30, H01H 5/02, H01H 25/04, H03K 17/97

(54) **INTERFACE HOMME-MACHINE**
MENSCH-MASCHINE-SCHNITTSTELLE
HUMAN-MACHINE INTERFACE

(30) Priorité: 03.04.2020 FR 2003361
(43) Date de publication de la demande: 08.02.2023
(73) Titulaire: Crouzet, 26000 Valence (FR)
(72) Inventeur: BEURDELEY, Damien, 26000 VALENCE (FR); CARTON, Hervé, 26000 VALENCE (FR); MOLMERET, Céline, 26000 VALENCE (FR); DUSSERE, Adrien, 26000 VALENCE (FR)
(74) Mandataire: INNOV-GROUP
(86) Numéro de dépôt international: PCT/EP2021/056469
(87) Numéro de publication internationale: WO 2021/197814

(56) Documents cités:
- EP-A1- 2 891 835
- FR-A1- 2 632 770
- JP-A- 2005 183 081
- US-A- 3 828 148
- US-A1- 2002 190 945

## Description

L'invention concerne une interface homme-machine.

De telles interfaces hommes-machines comportent typiquement :
- un châssis fixe,
- un ustensile déplaçable par un utilisateur, en rotation dans un premier sens, autour d'un premier axe, depuis une position neutre vers une première position inclinée, la position neutre étant la position de l'ustensile en absence de sollicitation extérieure sur cet ustensile, et
- un mécanisme de rappel qui sollicite en permanence l'ustensile vers sa position neutre, ce mécanisme de rappel comportant un ensemble magnétique comportant une ou plusieurs pièces magnétiques chacune fixée sur le châssis.

Par exemple, de telles interfaces hommes-machines sont connues de US2019179357A1 et US2018173310A1. Des interfaces hommes-machines sont également connues de US3828148A, JP2005183081A , FR2632770A1 et EP2891835

Ces interfaces hommes-machines sont utilisées pour acquérir des données transmises par l'utilisateur en manipulant l'ustensile. Ensuite, les données acquises sont transmises à un appareil électronique qui, en réponse, commande un actionneur électrique ou un écran.

De telles interfaces hommes-machines peuvent être utilisées dans des environnements soumis à des vibrations. C'est typiquement le cas lorsqu'une telle interface homme-machine est utilisée dans un véhicule comme un aéronef, un véhicule automobile ou similaire.

Dans ces environnements, ces interfaces hommes-machines doivent être résistantes aux vibrations. En particulier l'ustensile ne doit pas ou pratiquement pas osciller autour de sa position neutre en réponse à ces vibrations.

Par ailleurs, ces interfaces hommes-machines doivent conserver un faible encombrement et rester simples à fabriquer.

L'invention vise donc à proposer une interface homme-machine adaptée à une utilisation dans un environnement où elle peut être soumise à des vibrations. Elle a donc pour objet une telle interface homme-machine conforme à la revendication 1.

L'invention sera mieux comprise à la lecture de la description qui va suivre, donnée uniquement à titre d'exemple non limitatif et faite en se référant aux dessins sur lesquels :
- les figures 1 et 2 sont des illustrations schématiques, en perspectives et en coupe verticale, d'un premier mode de réalisation d'une interface homme-machine ;
- les figures 3, 4, 6 et 7 sont des illustrations schématiques, en perspectives et en coupe verticale, d'un deuxième mode de réalisation d'une interface homme-machine ;
- la figure 5 est une illustration, en perspective, d'un anneau aimanté utilisé dans l'interface homme-machine des figures 3, 4, 6 et 7 ;
- les figures 8 et 9 sont des illustrations schématiques, en perspectives et en coupe verticale, d'un troisième mode de réalisation d'une interface homme-machine ;
- les figures 10 et 11 sont des illustrations schématiques, en perspectives et en coupe verticale, d'un quatrième mode de réalisation d'une interface homme-machine ;
- la figure 12 est une illustration schématique, en coupe verticale, d'un cinquième mode de réalisation d'une l'interface homme-machine ;
- la figure 13 est une illustration schématique, en vue de dessus, d'une portion d'un sixième mode de réalisation d'une l'interface homme-machine ;
- la figure 14 est une illustration schématique, en vue de dessous, d'un anneau aimanté susceptible d'être utilisé dans les deuxième, troisième, quatrième et septième modes de réalisation d'une interface homme-machine;
- la figure 15 est une illustration schématique, en coupe verticale, d'un septième mode de réalisation d'une interface homme-machine.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description, des exemples détaillés de mode de réalisation sont d'abord décrits dans le chapitre I en référence aux figures. Ensuite, dans le chapitre Il suivant, des variantes de ces modes de réalisation sont présentées. Enfin, les avantages des différents modes de réalisation sont présentés dans un chapitre III.

### Chapitre I : Exemples de modes de réalisation :

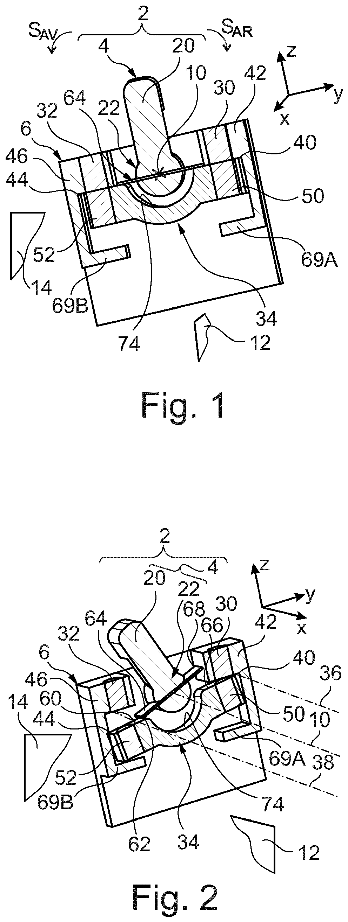

Les figures 1 à 2 représentent une interface homme-machine 2 comportant un ustensile 4 monté en rotation à l'intérieur d'un châssis 6. Ici, l'ustensile 4 est un levier. L'ustensile 4 est uniquement monté en rotation autour d'un seul axe 10. L'axe 10 est parallèle à une direction X d'un repère orthogonal XYZ. L'axe 10 est fixé, sans aucun degré de liberté, au châssis 6.

Dans ce repère XYZ, les directions X et Y sont horizontales et la direction Z est verticale. Par la suite, les termes tels que « haut », « bas », « supérieur », « inférieur » et similaires sont définis par rapport à la direction verticale Z. Les termes "gauche" et "droite" sont définis par rapport à la direction Y et à un plan médian vertical 12 de l'interface 2. Ainsi, le terme "droite" désigne ce qui se trouve à droite du plan 12 lorsque la direction Y pointe vers la droite. Le plan 12 contient l'axe 10. Par la suite, le repère XYZ est utilisé pour orienter chacune des figures.

Dans ce mode particulier de réalisation, dans une position neutre représentée sur la figure 1, l'interface 2 est symétrique par rapport au plan 12. De plus, l'interface 2 est également symétrique par rapport à un plan vertical 14 perpendiculaire au plan 12. Ainsi, par la suite, seuls les éléments de l'interface 2 situés d'un côté du plan 12 et derrière le plan 14 sont décrits en détails. Les autres éléments se déduisent par symétrie par rapport à ces plans 12 et 14.

La position neutre est la position de l'ustensile 4 en absence de sollicitation extérieure.

A partir de la position neutre, l'ustensile 4 est déplaçable en rotation autour de l'axe 10, par l'utilisateur, dans un sens avant S_{Av} et, en alternance, dans un sens arrière S_{AR}. Par exemple, l'utilisateur déplace l'ustensile 4 directement avec sa main ou avec un doigt. Les sens avant S_{Av} et arrière S_{AR} sont représentés par des flèches identifiées par, respectivement, les symboles S_{AV} et S_{AR} sur la figure 1. Ici, le sens S_{AV} est le sens antihoraire et le sens S_{AR} est le sens horaire.

L'ustensile 4 pivote, dans le sens S_{AV}, depuis la position neutre, vers une position inclinée à gauche représentée sur la figure 2. L'ustensile 4 est aussi capable de pivoter, dans le sens S_{AR}, depuis la position neutre, vers une position inclinée à droite. Typiquement, la position inclinée à droite est le symétrique de la position inclinée à gauche par rapport au plan 12. Le décalage angulaire α_{AV} entre la position neutre et la position la plus inclinée à gauche est ici compris entre 2° et 50° ou entre 2° et 45° ou entre 5° et 45°.

L'ustensile 4 comporte une poignée 20 de préhension accessible depuis l'extérieur du châssis 6 de manière à être directement actionnable à la main par l'utilisateur. Dans la position neutre, cette poignée 20 s'étend verticalement et vers le haut à partir d'un corps cylindrique 22. Le corps 22 est monté en rotation sur l'axe 10.

L'interface 2 comporte un mécanisme de rappel qui sollicite en permanence l'ustensile 4 vers sa position neutre. Le mécanisme de rappel comporte un ensemble magnétique fixé sans aucun degré de liberté sur le châssis 6. Cet ensemble magnétique comporte une ou plusieurs pièces magnétiques. Dans cette demande par « *pièce magnétique »* on désigne aussi bien un aimant permanent qu'une pièce magnétique non aimantée de façon permanente. Par *«pièce magnétique non aimantée de façon permanente »,* on désigne une pièce magnétique qui n'est pas aimantée en permanence, mais qui s'aimante lorsqu'elle est placée à l'intérieur d'un champ magnétique d'un aimant permanent. Une telle pièce magnétique non aimantée de façon permanente est donc attirée par un aimant permanent lorsqu'elle est située à proximité de ce dernier. Typiquement, les pièces magnétiques non aimantées de façon permanente sont des pièces réalisées dans un matériau ferromagnétique tel qu'un métal ferromagnétique. Par exemple, ici, les pièces non-aimantées de façon permanente sont en acier.

Dans ce 1^{er} mode de réalisation, l'ensemble magnétique comporte deux aimants permanents 30 et 32. L'aimant 30 est à droite du plan 12. Le moment magnétique de cet aimant 30 est vertical. L'aimant 30 comporte un pôle Sud tourné vers le bas et un pôle Nord tourné vers le haut.

Le mécanisme de rappel comporte aussi une bascule magnétique 34 déplaçable en rotation autour d'un axe 36 (figure 2) et, en alternance, autour d'un axe 38 (figure 2). Les axes 36 et 38 sont parallèles à l'axe 10 et distincts de l'axe 10. Ils sont fixes par rapport au châssis 6. Ici, l'axe 38 est le symétrique de l'axe 36 par rapport au plan 12.

Plus précisément, la bascule 34 est déplaçable en pivotant, autour de l'axe 36 dans le sens S_{AV}, depuis une position de repos, représentée sur la figure 1, jusqu'à une position penchée à gauche représentée sur la figure 2. Elle est également déplaçable en pivotant, autour de l'axe 38 dans le sens inverse S_{AR}, depuis la position de repos vers une position penchée à droite. La position penchée à droite est le symétrique, par rapport au plan 12, de la position penchée à gauche représentée sur la figure 2.

Dans la position de repos, la bascule 34 maintient l'ustensile 4 dans sa position neutre. Dans sa position penchée à gauche, l'ustensile 4 est dans sa position inclinée à gauche (figure 2). Dans sa position penchée à droite, l'ustensile 4 est dans sa position inclinée à droite.

Pour pivoter autour de l'axe 36, la bascule 34 comporte un point d'appui 40 déplaçable entre une position active et une position éloignée. Dans ce mode de réalisation, le point d'appui 40 est formé par un angle supérieur de la bascule 34. Dans la position active, le point 40 est directement en appui mécanique contre une butée 42 du châssis 6. Dans cette position active, le point 40 est situé sur l'axe 36 et forme, par coopération de forme avec la butée 42, une articulation qui permet à la bascule 34 de pivoter autour de l'axe 36. Dans la position éloignée, le point 40 n'est plus en contact mécanique avec la butée 42.

Les symétriques du point 40 et de la butée 42 par rapport au plan 12 portent, respectivement, les références numériques 44 et 46. Le point 44 et la butée 46 fonctionnent et remplissent les mêmes fonctions que le point 40 et la butée 42, mais pour permettre à la bascule 34 de pivoter autour de l'axe 38.

La bascule 34 coopère également avec les aimants 30 et 32 pour générer la force de rappel qui sollicite en permanence l'ustensile 4 vers sa position neutre. Ici, la force de rappel est générée par attraction magnétique entre la bascule 34 et les aimants 30 et 32. Pour cela, la bascule 34 comporte deux aimants permanents 50 et 52. L'aimant 50 est situé à droite du plan 12. Le moment magnétique de l'aimant 50 est vertical. L'aimant 50 comporte un pôle Sud et un pôle Nord. Le pôle Nord de l'aimant 50, dans la position de repos, est tourné vers le haut. Dans la position de repos, ce pôle Nord est situé en vis-à-vis du pôle Sud de l'aimant 30. Ici, dans la position de repos, le pôle Nord de l'aimant 50 est collé sur le pôle Sud de l'aimant 30. Ainsi, en absence de sollicitation extérieure, la bascule 34 revient vers sa position de repos.

Lorsque la bascule 34 se déplace entre sa position de repos et sa position penchée à gauche, le point 40 est maintenu dans sa position active par la force d'attraction magnétique entre les aimants 30, 32 et les aimants 50 et 52. Dans le même temps, dans cette situation, le point 44 est dans sa position éloignée.

De façon similaire, lorsque la bascule 34 se déplace entre sa position de repos et sa position penchée à droite, le point 44 est maintenu dans sa position active par la force d'attraction magnétique entre les aimants 30, 32 et les aimants 50, 52. Dans ce cas, le point 40 est dans sa position éloignée.

Enfin, le mécanisme de rappel comporte aussi une liaison glissière entre l'ustensile 4 et la bascule 34. Cette liaison glissière comporte une partie gauche située à gauche du plan 12. La partie gauche de la liaison glissière comporte un méplat 60 (figure 2) et un coulisseau 62 (figure 2). Ici, le méplat 60 s'étend dans une direction perpendiculaire à l'axe 10. Dans la position de repos, cette direction est horizontale. Cette partie gauche transforme un déplacement de l'ustensile 4 depuis sa position neutre vers sa position inclinée à gauche, en un déplacement de la bascule 34 depuis sa position de repos vers sa position penchée à gauche. Cette partie gauche de la liaison glissière transforme également un déplacement de la bascule 34 depuis sa position penchée à gauche vers sa position de repos, en un déplacement de l'ustensile 4 depuis sa position inclinée à gauche vers sa position neutre.

Pour cela, le coulisseau 62 glisse le long du méplat 60 lorsque l'ustensile 4 est déplacé entre la position neutre et la position inclinée à gauche. Le coulisseau 62 est aussi en appui sur le méplat 60 dans la position neutre de l'ustensile 4. Le coulisseau 62 est situé à au moins 1 mm ou 3 mm de l'axe 10 et, dans certains modes de réalisation, à plus de 5 mm ou 10 mm de l'axe 10. Le coulisseau 62 est fixé sans aucun degré de liberté à l'ustensile 4. Dans ce mode de réalisation, le coulisseau 62 est formé par un bord gauche d'une lame 64. La lame 64 est fixée sur le corps 22. Dans la position neutre, la lame 64 s'étend horizontalement.

Cette liaison glissière comporte aussi une partie droite symétrique de la partie gauche par rapport au plan 12 dans la position neutre. Cette partie droite transforme un déplacement de l'ustensile 4 depuis sa position neutre vers sa position inclinée à droite en un déplacement de la bascule 34 depuis sa position de repos vers sa position penchée à droite. Cette partie droite de la liaison glissière transforme également un déplacement de la bascule 34 depuis sa position penchée à droite vers sa position de repos en un déplacement de l'ustensile 4 depuis sa position inclinée à droite vers sa position neutre.

Les symétriques du méplat 60 et du coulisseau 62 par rapport au plan 12, portent, respectivement, les références numériques 66 et 68 (figure 2).

Le châssis 6 comporte aussi dans ce mode de réalisation, deux butées 69Aet 69B situées, respectivement, à droite et à gauche du plan 12 et symétriques l'une de l'autre par rapport à ce plan. La butée 69B limite la course angulaire de la bascule 34 lorsqu'elle tourne autour de l'axe 36 dans le sens S_{AV}.

Le fonctionnement de l'interface 2 est le suivant. En absence de sollicitation extérieure, la force de rappel exercée par les aimants 30, 32 et les aimants 50, 52 maintient la bascule 34 dans sa position de repos. Dans la position de repos, les coulisseaux 62 et 68 sont simultanément en appui sur les méplats 60 et 66 et éloignés de l'axe 10. La lame 64 maintient donc l'ustensile 4 dans sa position neutre. Le couple nécessaire pour déplacer l'ustensile 4 vers l'une de ses positions inclinées est donc important.

Lorsqu'un utilisateur pousse la poignée 20 dans le sens S_{AV}, l'ustensile 4 se déplace depuis sa position neutre vers la position inclinée à gauche. Plus précisément, dans ce mode de réalisation, initialement, la lame 64 se courbe du côté gauche avant que la bascule commence à tourner autour de l'axe 36. Ensuite, la rotation de l'ustensile 4 est transformée, par la liaison glissière, en une rotation de la bascule 34 depuis sa position de repos vers sa position penchée à gauche. Ici, dans la position penchée à gauche, la bascule 34 est en appui contre la butée 69B. La rotation de la bascule 34 dans le sens S_{AV} est alors bloquée. Toutefois, dans cet exemple de mode de réalisation, en augmentant la force de poussée sur la poignée 20, la lame 64 se courbe à nouveau, ce qui permet à l'utilisateur de poursuivre le déplacement en rotation autour de l'axe 10 et dans le sens S_{AV} de l'ustensile 4 jusqu'à ce que cet ustensile vienne en appui sur un rebord du châssis 6. Ainsi, dans ce mode de réalisation, pour aller au-delà de la position inclinée à gauche représentée sur la figure 2, l'utilisateur doit augmenter sa force de poussée.

Lorsque l'utilisateur relâche la force qu'il a exercée sur l'ustensile 4, l'ustensile 4 n'est plus soumis à aucune sollicitation extérieure. La force de rappel générée par les aimants 30, 32 et 50, 52 ramène alors la bascule 34 dans sa position de repos. La partie gauche de la liaison glissière transforme ce dépassement de la bascule 34 en déplacement de l'ustensile 4 depuis sa position inclinée à gauche jusqu'à sa position neutre.

Le fonctionnement de l'interface 2 lorsque l'ustensile 4 est déplacé par un utilisateur depuis sa position neutre jusqu'à sa position inclinée à droite se déduit des explications ci-dessus.

En parallèle de ces déplacements, des capteurs, non représentés sur les figures 1 et 2, mesurent en permanence la position angulaire de l'ustensile 4 autour de l'axe 10. Les données acquises par ces capteurs sont transmises à un appareil de commande qui commande en fonction des données acquises, un ou plusieurs actionneurs électriques ou écrans.

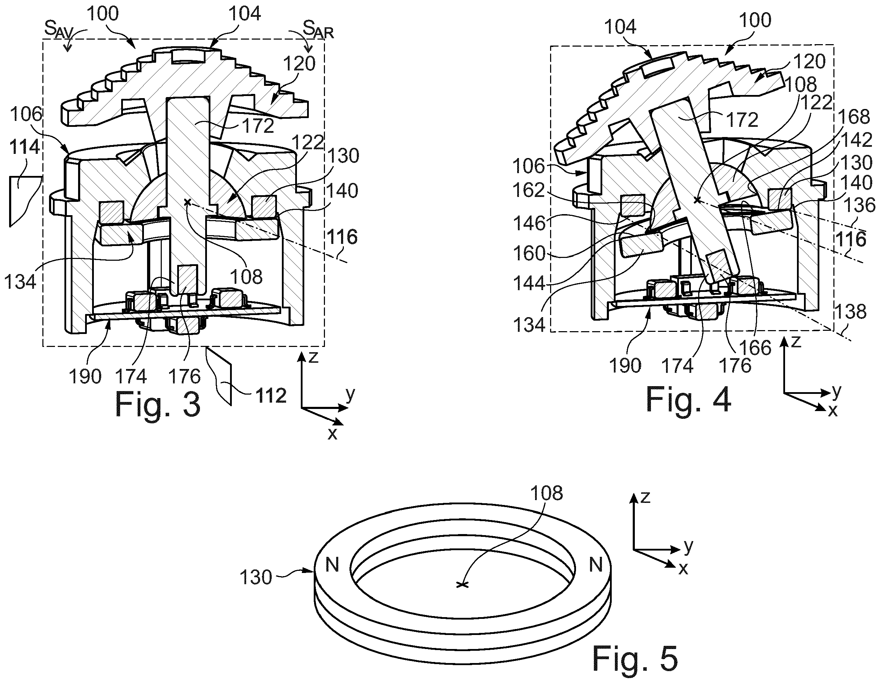

Les figures 3 à 4 représentent une interface homme-machine 100 qui reprend les principaux principes de fonctionnement de l'interface 2 mais dans le cas d'un joystick.

L'interface 100 comporte un ustensile 104 monté en rotation à l'intérieur d'un châssis 106. L'ustensile 104 est un levier. L'ustensile 104 est mécaniquement raccordé au châssis 106 par une liaison rotule. Ainsi, il est monté en rotation autour d'une infinité d'axes de rotation horizontaux se coupant tous en un point 108 appelé par la suite "centre 108 de rotation". Le centre 108 est fixé, sans aucun degré de liberté, au châssis 106.

Dans une position neutre représentée sur la figure 3, l'interface 100 est symétrique par rapport à un plan vertical 112 passant par le centre 108. De plus, l'interface 100 est également symétrique par rapport à un plan vertical 114 perpendiculaire au plan 12 et passant par le centre 108. Ainsi, comme précédemment, seuls les éléments de l'interface 100 situés d'un côté du plan 112 et derrière le plan 114 sont décrits en détails. Les autres éléments se déduisent par symétrie par rapport à ces plans 112 et 114. De plus, la suite de la description est faite dans le cas particulier où l'ustensile 104 pivote autour d'un axe 116 parallèle à la direction X et passant par le centre 108. Ce qui est décrit dans ce cas particulier, s'applique à tout axe passant par le centre 108 et autour duquel l'ustensile 104 peut pivoter. Dans ce cas particulier, le plan 112 contient l'axe 116.

L'ustensile 104 pivote, autour de l'axe 116 et dans le sens S_{Av}, depuis la position neutre vers une position inclinée à gauche représentée sur la figure 4. L'ustensile 104 est aussi capable de pivoter, autour de l'axe 116 dans le sens S_{AR}, depuis la position neutre, vers une position inclinée à droite. Typiquement, la position inclinée à droite est la symétrique de la position inclinée à gauche par rapport à un plan 112. Le décalage angulaire α_{AV} entre la position neutre et la position la plus inclinée à gauche est ici compris entre 2° et 50° ou entre 21° et 45° ou entre 5° et 45°.

L'ustensile 104 comporte une poignée 120 de préhension accessible depuis l'extérieur du châssis 6 de manière à être directement actionnable, par exemple, à la main par l'utilisateur. Cette poignée 120 fait saillie au-delà du châssis 106. La poignée 120 est mécaniquement raccordée à un corps hémisphérique 122 par un arbre 172. Dans ce mode de réalisation, l'arbre 172 est fixé sans aucun degré de liberté au corps 122. Le corps 122 est monté en rotation dans le châssis 106 par l'intermédiaire d'une liaison rotule.

L'interface 100 comporte un mécanisme de rappel qui sollicite en permanence l'ustensile 104 vers sa position neutre. Ce mécanisme de rappel comporte un ensemble magnétique fixé sans aucun degré de liberté sur le châssis 106. Dans ce mode de réalisation, l'ensemble magnétique comporte un anneau aimanté 130 dont l'axe de révolution est vertical et passe par le centre 108. Cet anneau 130 est représenté seul sur la figure 5. Le moment magnétique de cet anneau 130 est vertical. Il comporte un pôle Sud tourné vers le bas et un pôle Nord tourné vers le haut.

Le mécanisme de rappel comporte une bascule magnétique 134 déplaçable en rotation autour d'un axe 136 (figure 4) et, en alternance, autour d'un axe 138 (figure 4). Les axes 136 et 138 sont parallèles à l'axe 116 et distincts de l'axe 116. Ils sont également fixés, sans aucun degré de liberté, au châssis 106. L'axe 138 est le symétrique de l'axe 136 par rapport au plan 112.

Plus précisément, la bascule 134 est déplaçable, en pivotant autour de l'axe 136 dans le sens S_{Av}, depuis une position de repos représentée sur la figure 3 jusqu'à une position penchée à gauche représentée sur la figure 4. La bascule 134 est également déplaçable, en pivotant autour de l'axe 138 dans le sens S_{AR}, depuis la position de repos vers une position penchée à droite. La position penchée à droite est le symétrique, par rapport au plan 112, de la position penchée à gauche représentée sur la figure 4.

Dans la position de repos, la bascule 134 maintient l'ustensile 104 dans sa position neutre. Dans la position penchée à gauche de la bascule 134, l'ustensile 104 est dans sa position inclinée à gauche. Dans sa position penchée à droite, l'ustensile 104 est dans sa position inclinée à droite. Pour pivoter autour de l'axe 136, la bascule 134 comporte un point 140 d'appui déplaçable entre une position active et une position éloignée. Dans la position active, le point 140 est directement en appui mécanique sur une butée 142 du châssis 106. Cette position active du point 140 est obtenue lorsque la bascule 134 est penchée à gauche. Dans ce mode de réalisation, la butée 142 est formée par une face inférieure de l'anneau 130. Le fonctionnement du point d'appui 140 et de la butée 142 est identique à celui du point 40 et de la butée 42 décrit dans le cas de l'interface 2. Le symétrique du point 140 et de la butée 142 par rapport au plan 112 portent, respectivement, les références numériques 144 et 146.

La bascule 134 coopère avec l'anneau 130 pour générer la force de rappel qui sollicite en permanence l'ustensile 104 vers sa position neutre. Comme dans le cas de l'interface 2, la force de rappel est générée par attraction magnétique entre la bascule 134 et l'anneau 130.

Pour cela, dans ce mode de réalisation, la bascule 134 se présente sous la forme d'une rondelle réalisée dans un matériau magnétique non aimantée de façon permanente. Dans la position de repos, l'axe de révolution de la bascule 134 est confondu avec l'axe de révolution de l'anneau 130. Ainsi, la bascule 134 concentre et guide les lignes de champ de l'anneau 130. Par conséquent, en présence de l'anneau 130, la bascule 134 acquiert une aimantation et présente alors un pôle Nord en vis-à-vis du pôle Sud de l'anneau 130. Ici, dans la position de repos, le pôle Nord de la bascule 134 est directement plaqué contre le pôle Sud de l'anneau 130. En absence de sollicitation extérieure, la bascule 134 revient donc dans sa position de repos.

Ici, les points 140 et 144 sont des points diamétralement opposés d'une arête supérieure de la bascule 134.

Comme dans le cas de l'interface 2, les points 140 et 144 sont maintenus dans leur position active respective par la force d'attraction magnétique entre l'anneau 130 et la rondelle 150. Ainsi, les mêmes éléments de l'interface 100 que ceux utilisés pour générer la force de rappel de l'ustensile 4 vers sa position neutre, sont également utilisés pour maintenir le point 140 et, en alternance, 144 dans sa position active.

Le mécanisme de rappel comporte aussi une liaison glissière entre l'ustensile 104 et la bascule 134. Comme dans l'interface 2, cette liaison glissière comporte une partie gauche et une partie droite situées, respectivement, à gauche et à droite du plan 112. La partie gauche de la liaison glissière comporte un méplat 160 et un coulisseau 162. Le coulisseau 162 est formé par un point d'une arête inférieure du corps 122. Les symétriques du méplat 160 et du coulisseau 162 par rapport au plan 112 portent, respectivement, les références numériques 166 et 168 (figure 4). Cette liaison glissière fonctionne exactement comme la liaison glissière décrite dans le cas de l'interface 2. Ainsi, elle n'est pas décrite ici plus en détail.

L'extrémité supérieure de l'arbre 172 est mécaniquement raccordée à la poignée 120. Une extrémité inférieure 174 de l'arbre 172 est située sous la bascule 134. A cet effet, l'arbre 172 passe à travers l'orifice central de la bascule 134. Cette extrémité inférieure 174 comporte un aimant permanent 176.

L'interface 100 comporte aussi une carte électronique 190 (Figures 3 et 4) équipée d'un ou plusieurs capteurs capables de mesurer le champ magnétique généré par l'aimant 176. La carte 190 comporte aussi un calculateur électronique capable d'établir la position angulaire de l'ustensile 104 autour du centre 108 à partir des mesures de ces capteurs. La carte 190 comporte aussi un émetteur capable de transmettre la position angulaire établie.

Le fonctionnement de l'interface 100 se déduit des explications données dans le cas de l'interface 2, sauf qu'ici, l'ustensile 104 peut en plus être déplacé en rotation par l'utilisateur autour de n'importe quel axe horizontal passant par le centre 108.

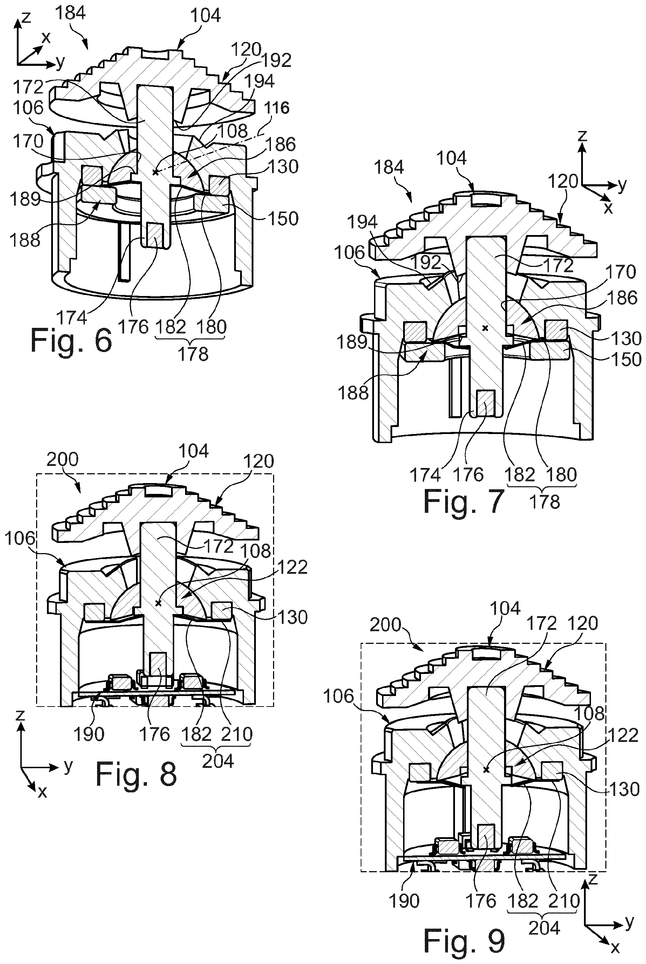

Les figures 6 à 7 représentent une interface 184 identique à l'interface 100 sauf que, en plus, la poignée 120 est déplaçable, par l'utilisateur, en translation verticalement entre une position relâchée, représentée sur la figure 6, et une position enfoncée représentée sur la figure 7. Ainsi, dans ce mode de réalisation, la poignée 120 joue également le rôle d'un poussoir. Pour cela, le corps 122 et la bascule 134 sont remplacés par, respectivement, un corps 186 et une bascule 188.

Le corps 186 est identique au corps 122 sauf qu'il comporte en plus une coulisse 170. Dans la position neutre, la coulisse 170 s'étend le long d'un axe vertical passant par le centre 108. Par exemple, la coulisse 170 est un trou traversant de part en part le corps 186. L'arbre 172 de l'ustensile 104 est reçu à coulissement à l'intérieur de la coulisse 170.

La bascule 188 comporte une rondelle 150 et une lame ressort 178 qui sollicite en permanence la poignée 120 vers sa position relâchée. La rondelle 150 est identique à la bascule 134.

Dans ce mode de réalisation, la lame 178 a la forme d'une coupelle présentant une périphérie circulaire plane 180 et un bossage central 182. La périphérie circulaire 180 est en appui sur une face supérieure de la rondelle 150. Le bossage 182 est traversé de part en part par l'arbre 172. Le bossage central 182 est en appui sur un épaulement 189 de l'arbre 172. Plus précisément, dans la position neutre et en absence de sollicitation extérieure, la lame 178 exerce une force Fₚ de poussée pour retenir la poignée 120 dans sa position relâchée. La force Fₚ est verticale et dirigée vers le haut. L'amplitude de la force Fₚ est inférieure à l'amplitude de la force Fᵣ de rappel générée par l'anneau aimanté 130 et la rondelle 150 dans la position neutre. Ainsi, lorsqu'un utilisateur exerce sur la poignée 120 une force verticale et dirigée vers le bas dont l'amplitude est comprise entre les amplitudes des forces Fₚ et Fᵣ, la poignée 120 se déplace depuis sa position relâchée vers sa position enfoncée sans que la bascule 188 ne se déplace. Dès que l'utilisateur relâche la poignée 120, la lame 178 la ramène dans sa position relâchée. Par exemple, la lame 178 est réalisée dans un matériau non-magnétique.

La poignée 120 comporte ici une face d'appui 192 (Figures 6 et 7) hémisphérique qui vient en appui glissant, par exemple comme représenté sur la figure 4, sur une face d'appui supérieure 194 correspondante du châssis 106 lorsque l'ustensile 104 est dans l'une quelconque de ses positions inclinées. Ainsi, dans les positions inclinées, il n'est pas possible de déplacer la poignée 120 vers sa position enfoncée. La poignée 120 peut seulement être déplacée vers sa position enfoncée lorsque l'ustensile 104 est dans sa position neutre.

Dans ce mode de réalisation, le calculateur de la carte 190 est en plus programmé pour déterminer à partir des mêmes mesures des capteurs, si la poignée 120 est dans sa position relâchée ou dans sa position enfoncée. La position relâchée ou enfoncée de la poignée 120 est ensuite transmise à un appareil de commande extérieure.

Le fonctionnement de l'interface 184 se déduit des explications données dans le cas de l'interface 100, sauf qu'ici, l'ustensile 104 peut en plus être déplacé entre la position relâchée et la position enfoncée.

Les figures 8 et 9 représentent une interface 200 identique à l'interface 184 sauf que la bascule 188 est remplacée par une bascule magnétique 204. La bascule 204 est identique à la bascule 188 sauf que la rondelle 150 et la lame 178 sont remplacées par une seule et même pièce magnétique qui remplit à la fois les fonctions de la rondelle 150 et de la lame 178. Par exemple, la bascule 204 est identique à la coupelle 178 sauf que sa périphérie circulaire 180 est remplacée par une périphérie circulaire 210 plus large. La périphérie circulaire 210 s'étend dans la position de repos jusqu'à la face inférieure de l'aimant 130 et se trouve donc en vis-à-vis de cette face inférieure de l'anneau 130. De plus, la bascule 204 est entièrement réalisée dans un matériau magnétique non aimanté de façon permanente. Dès lors, dans la position de repos de la bascule 204, telle que représentée sur les figures 8 et 9, la périphérie circulaire 210 est collée sur la face inférieure de l'anneau 130.

Le fonctionnement de l'interface 200 est identique à celui de l'interface 184 sauf que la bascule 204 n'est formée que d'un seul bloc de matière.

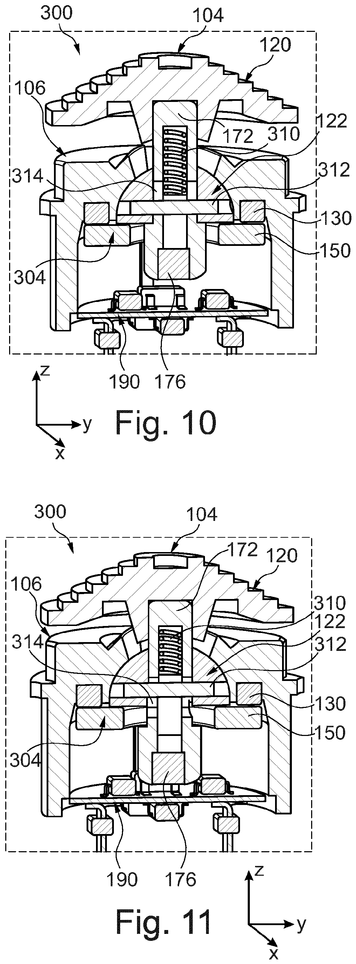

Les figures 10 et 11 représentent une interface 300 identique à l'interface 184, sauf que la bascule 188 est remplacée par une bascule magnétique 304. La bascule 304 est identique à la bascule 188 sauf que la lame 178 est omise. Dans ces conditions, pour ramener la poignée 120 dans sa position relâchée, l'interface 300 comporte un ressort hélicoïdal 310. Une extrémité supérieure du ressort 310 est directement en appui sur l'arbre 172 et une extrémité inférieure du ressort 310 est en appui sur une clavette 312. La clavette 312 est fixée, sans aucun degré de liberté, sur le corps 122 et passe à travers un trou horizontal 314 traversant de part en part l'arbre 172. Ici, le ressort 310 est reçu à l'intérieur d'un logement tubulaire creux aménagé à l'intérieur de l'arbre 172.

Le ressort 310 repousse en permanence la poignée 120 dans sa position relâchée représentée sur la figure 10. L'amplitude de cette force est identique à l'amplitude de la force Fₚ décrite dans le cas de l'interface 184.

Lorsque l'utilisateur applique une force verticale dirigée vers le bas dont l'amplitude est comprise entre les amplitudes des forces Fₚ et Fᵣ, la poignée 120 se déplace, à l'encontre de la force de rappel du ressort 310, vers sa position enfoncée représentée sur la figure 11. Le reste du fonctionnement de l'interface 300 est identique au fonctionnement de l'interface 100.

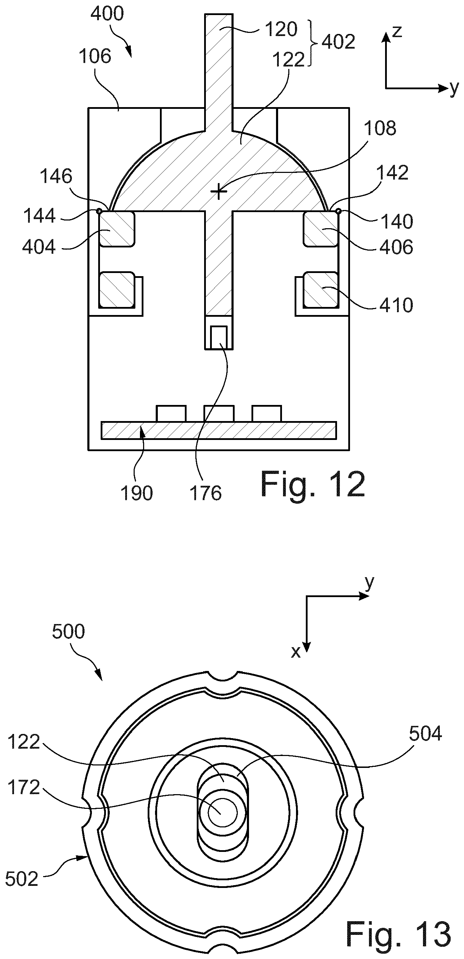

La figure 12 représente une interface 400 identique à l'interface 100 sauf que :
- l'ustensile 104 est remplacé par un ustensile 402 ;
- la bascule magnétique 134 est remplacée par une bascule magnétique 404 ;
- l'ensemble magnétique fixé sur le châssis 106 est agencé pour repousser en permanence la bascule 404 vers sa position de repos représentée sur la figure 12.

L'ustensile 402 est identique à l'ustensile 104 sauf que l'arbre 172 et le corps 122 sont formés dans le même bloc de matière. Ainsi, dans ce mode de réalisation, il n'est pas possible de déplacer cette poignée 120 entre une position relâchée et une position enfoncée en exerçant sur la poignée 120 une force verticale dirigée vers le bas dont l'amplitude est comprise entre les amplitudes des forces Fₚ et Fᵣ.

La bascule 404 se présente sous la forme d'un anneau aimanté. Par exemple, la bascule 404 est identique à l'anneau 130. Son pôle Nord est tourné vers le haut et son pôle Sud est tourné vers le bas.

L'ensemble magnétique est agencé pour repousser vers le haut et donc vers sa position de repos, la bascule 404. A cet effet, l'ensemble magnétique comporte un anneau aimanté 410 fixé, sans aucun degré de liberté, sur le châssis 106 et situé en dessous de la bascule 404. Comme la bascule 404, l'anneau 410 s'étend principalement horizontalement. L'axe de révolution de l'anneau 410 est vertical et confondu avec l'axe de révolution de la bascule 404. L'anneau 410 est par exemple structurellement identique à la bascule 404 sauf que son pôle Sud est tourné vers le haut. Le pôle Sud de l'anneau 410 se trouve donc en vis-à-vis du pôle Sud de la bascule 404. Dans ces conditions, l'anneau 410 repousse en permanence la bascule 404 vers sa position de repos.

Dans ce mode de réalisation, la bascule 404 et l'anneau 410 coopèrent pour générer une force de rappel dont l'amplitude augmente au fur et à mesure que l'ustensile 102 s'incline vers la droite ou vers la gauche. Le reste du fonctionnement de l'interface 400 se déduit des explications précédemment données dans le cas, par exemple, de l'interface 100.

La figure 13 représente une interface 500 identique à l'interface 100 sauf que le seul axe autour duquel peut pivoter l'ustensile 104 est l'axe 116. Pour cela, le châssis 106 est remplacé par un châssis 502. Le châssis 502 est identique au châssis 106 sauf que sa face supérieure est conformée pour empêcher tout déplacement en rotation de l'ustensile 104 sauf autour de l'axe 116. Pour simplifier cette figure 13, seule une portion de la face supérieure du châssis 502 et l'arbre 172 sont représentés. A cet effet, la face supérieure du châssis 502 comporte une fente rectiligne 504 qui guide en translation l'arbre 172. Cette fente s'étend dans la direction Y.

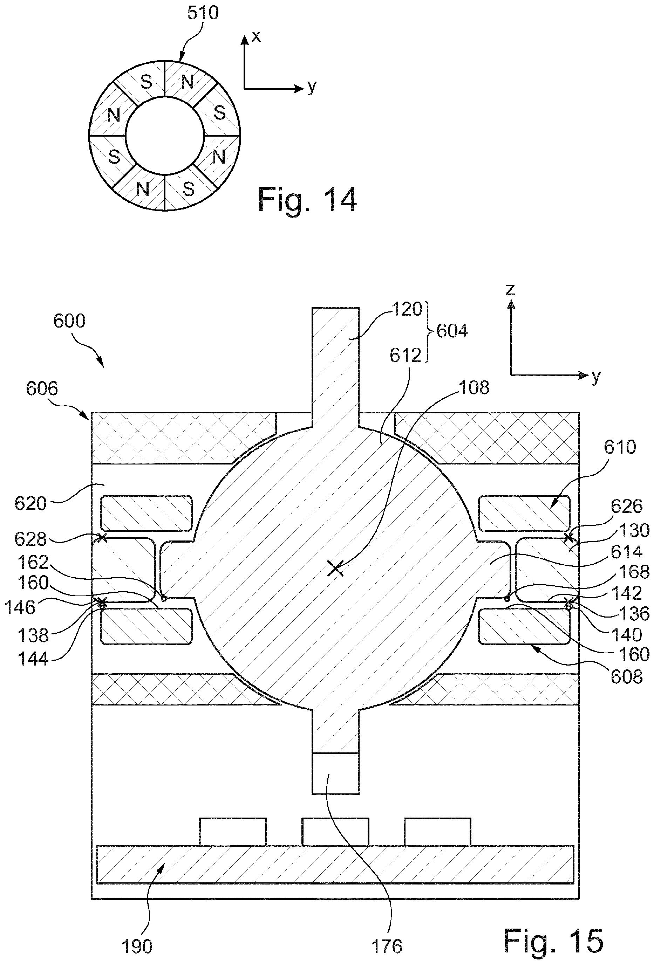

La figure 14 représente un anneau aimanté 510 susceptible d'être utilisé à la place de l'anneau 130 dans l'interface 100. Cet anneau 510 présente, sur sa face inférieure horizontale, plusieurs pôles Sud et plusieurs pôles Nord. Sur la figure 14, les pôles Sud et les pôles Nord sont désignés par les lettres respectivement « S » et « N ». Les pôles Nord et Sud de l'anneau 510 sont juxtaposés les uns aux autres et disposés immédiatement les uns après les autres le long de la face inférieure de cet anneau 510. Chaque pôle Sud est coincé et interposé entre deux pôles Nord.

Le fonctionnement de l'interface 100 dans laquelle l'anneau 130 est remplacé par l'anneau 510 est identique à celui décrit dans le cas où c'est l'anneau 130 qui est utilisé. Toutefois, les lignes de champ de l'anneau 510 se rebouclent plus rapidement par l'intermédiaire de la rondelle 150. Ces lignes de champs sont donc plus courtes que dans le cas où c'est l'anneau 130 qui est utilisé. Cela réduit le risque de perturber le fonctionnement d'un composant électronique situé à proximité de l'anneau 510.

La figure 15 représente une interface 600 identique à l'interface 100 sauf que :
- l'ustensile 104 est remplacé par un ustensile 604,
- le châssis 106 est remplacé par un châssis 606, et
- la bascule magnétique 134 est remplacée par deux bascules magnétiques 608 et 610.

L'ustensile 604 est identique à l'ustensile 104 sauf que le corps hémisphérique 122 est remplacé par un corps 612 essentiellement sphérique. Le corps 612 forme la partie mâle d'une liaison rotule entre l'ustensile 604 et le châssis 606. De plus, le corps 612 comporte un épaulement circulaire 614 qui fait le tour complet de sa partie sphérique. Dans la position neutre, l'épaulement 614 s'étend dans un plan horizontal. Dans la position neutre, l'épaulement 614 est symétrique par rapport à un plan horizontal passant par le centre 108 de rotation. De plus, dans ce mode de réalisation, les bascules 608 et 610 sont symétriques l'une de l'autre par rapport à ce même plan horizontal. Ainsi, par la suite, seuls les éléments de l'épaulement 614 situés en-dessous de ce plan horizontal et seule la bascule 608 sont décrits plus en détail. Les éléments de l'interface 600 qui se trouvent au-dessus de ce plan horizontal se déduisent par symétrie.

L'épaulement 614 comporte une arrête inférieure qui forme les coulisseaux 162 et 168 de la liaison glissière entre l'ustensile 604 et la bascule 608.

Ici, la poignée 120 est fixée sans aucun degré de liberté au corps 612. Ainsi, il n'est pas possible de déplacer cette poignée 120 entre une position relâchée et une position enfoncée en exerçant sur la poignée 120 une force verticale dirigée vers le bas dont l'amplitude est comprise entre les amplitudes des forces Fₚ et Fᵣ.

La bascule 608 est identique à la bascule 134. Elle est déplacée entre des positions penchées à droite et à gauche comme déjà décrit dans le cas de la bascule 134. La bascule 610 est identique à la bascule 608 sauf qu'elle est placée de l'autre coté de l'anneau 130.

Le châssis 606 est identique au châssis 106 sauf qu'il comporte un évidement supplémentaire 620 qui permet à la bascule 610 de se déplacer entre la position de repos représentée sur la figure 15 et des positions penchées à gauche et à droite. La position penchée à gauche de la bascule 610 est le symétrique de la position penchée à gauche de la bascule 608 par rapport au centre 108. De même, la position penchée à droite de la bascule 608 est le symétrique de la position penchée à droite de la bascule 608 par rapport au centre 108.

Dans ce mode de réalisation, la bascule 610 fonctionne et se déplace comme la bascule 608 sauf qu'elle pivote autour d'un axe situé, par rapport à un plan vertical passant par le centre 108, du côté opposé au côté contenant l'axe autour duquel pivote la bascule 608. A titre d'illustration, sur la figure 15, les axes symétriques des axes 136 et 138 par rapport au centre 108 portent, respectivement, les références numériques 628 et 626. En effet, lorsque l'ustensile 604 se déplace vers sa position inclinée à gauche, l'épaulement 614 déplace en même temps les bascules 608 et 610 vers leurs positions penchées à gauche. Ainsi, dans ce mode de réalisation, la force de rappel Fᵣ qui ramène l'ustensile 604 dans sa position neutre en absence de sollicitation extérieure est générée par la coopération de l'anneau 130 avec les deux bascules 608 et 610. Cela permet donc de doubler l'amplitude de la force de rappel.

### Chapitre II : Variantes :

### Variantes du mécanisme de rappel :

En variante, la bascule 134 ou la rondelle 150 est remplacée par un anneau aimanté de même forme et dont le pôle Nord est tourné vers le haut. De même, dans l'interface 200, la bascule 204 peut être remplacée par une coupelle structurellement identique, mais aimantée de façon permanente et dont le pôle Nord est tourné vers le haut. Dans ces variantes, à la fois l'ensemble magnétique et la bascule magnétique comportent un aimant permanent.

Quel que soit le mode de réalisation, les positions des aimants permanents et des pièces magnétiques non aimantées de façon permanente peuvent être interverties. Par exemple, l'anneau 130 peut être remplacé par une rondelle métallique non aimantée de façon permanente et la rondelle 150 peut être remplacée par un anneau aimanté.

Dans les modes de réalisations décrits jusqu'à présent, l'ensemble magnétique et la bascule magnétique comportent soit seulement des aimants permanents, soit seulement des pièces magnétiques non aimantées de façon permanente. Toutefois, en variante, chacun de l'ensemble magnétique et de la bascule magnétique peut comporter à la fois des aimants permanents et des pièces magnétiques non aimantées de façon permanente.

En variante, l'ensemble magnétique et/ou la bascule magnétique comportent une cale non magnétique qui est interposée, dans la position neutre, entre l'ensemble magnétique et la bascule magnétique. Cette cale introduit donc, dans la position neutre, un espace entre l'ensemble magnétique et la bascule magnétique. Plus cet espace est important, plus le moment minimal à exercer pour déplacer l'ustensile depuis sa position neutre vers l'une de ses positions inclinées diminue. Ainsi, l'épaisseur de cette cale permet de régler l'amplitude de ce moment minimal. La cale peut être fixée sur le châssis ou sur la bascule magnétique ou une cale peut être fixée sur le châssis et une autre cale peut être fixée sur la bascule magnétique. De plus, si cette cale est réalisée dans un matériau souple comme un matériau élastomère, elle permet en plus d'amortir le bruit de claquement qui peut se produire lorsque la bascule magnétique revient dans sa position de repos.

### Autres variantes :

De nombreuses formes différentes sont possibles pour l'ustensile. Par exemple, l'ustensile 4 peut être remplacé par une molette qui pivote autour de l'axe 10. L'ustensile peut également comporter un ou plusieurs boutons-poussoirs déplaçables chacun entre une position sortie et une position enfoncée par un doigt de l'utilisateur lorsque celui-ci agrippe l'ustensile.

Dans une variante simplifiée, l'ustensile est seulement déplaçable entre la position neutre et la position inclinée à gauche. Par exemple, pour cela, le châssis comporte une butée qui empêche tout déplacement de l'ustensile vers la position inclinée à droite. Dans ce cas, la bascule tourne uniquement autour de l'axe de rotation situé à droite. Tous les éléments de l'interface qui permettent en plus à la bascule de tourner autour d'un axe situé à gauche peuvent alors être omis. De plus, le point d'appui situé à droite est alors systématiquement dans sa position active. Il n'est alors plus nécessaire que ce point d'appui puisse être déplacée vers sa position éloignée.

Le nombre d'axes horizontaux autour desquels peut pivoter l'ustensile peut être égal à un comme illustré sur les figures 1, 2 et 13, ou être infini comme illustré sur les figures 3 à 12 et 15. Ce nombre peut aussi être compris entre ces deux cas extrêmes. Ainsi, le nombre d'axes horizontaux autour desquels l'ustensile pivote peut être supérieur ou égal à deux et inférieur ou égal à six ou quatre. Pour cela, par exemple, le châssis est agencé de façon à limiter le nombre d'axes horizontaux de rotation comme cela a été illustré dans le cas particulier d'un seul axe de rotation en référence à la figure 13.

L'ustensile peut aussi être conformé pour être déplacé autrement que par la main de l'utilisateur. Par exemple, en variante, l'ustensile est conformé pour être déplacé par un pied de l'utilisateur. L'ustensile peut aussi être déplacé par un robot ou autre. Ainsi, l'interface homme-machine décrite ici peut aussi être employée dans d'autres domaines que celui des interfaces homme-machine. Par exemple, elle peut être utilisée comme détecteur de fin de course ou comme capteur d'un déplacement d'un objet mécanique.

D'autres modes de réalisation de la liaison glissière sont possibles. Par exemple, dans un mode de réalisation particulier, les positions du coulisseau et du méplat sont interverties. L'un du coulisseau et du méplat est alors fixé sur la bascule et l'autre du coulisseau et du méplat est fixé sur l'ustensile. Dans un autre mode de réalisation, les parties droite et gauche de la liaison glissière ne sont pas symétriques l'une de l'autre. Par exemple, seulement dans la partie droite de la liaison glissière, les positions du coulisseau et du méplat sont interverties.

La lame 64 peut être remplacée par un ressort de torsion qui comprend deux extrémités et une portion centrale qui s'étend entre ces deux extrémités. Par exemple, la portion centrale est enroulée autour de l'axe 10. Dans la position neutre, les extrémités du ressort de torsion sont en appui sur, respectivement, les méplats 60 et 66. Ces extrémités coulissent sur ces méplats lorsque l'ustensile 4 est incliné. Ainsi, ces extrémités forment les coulisseaux de la liaison glissière entre l'ustensile et la bascule.

En variante, la force de rappel magnétique, qui sollicite en permanence la bascule magnétique vers sa position de repos, ne suffit pas à elle-seule, en absence de sollicitation extérieure, pour ramener l'ustensile depuis sa position inclinée jusqu'à sa position neutre. Dans ce cas, en complément de la force de rappel générée par l'interaction magnétique entre la bascule magnétique et l'ensemble magnétique, un ou plusieurs ressorts peuvent être utilisés pour solliciter en permanence l'ustensile vers sa position neutre. Par exemple, pour cela, la lame 64 est remplacée par deux ressorts de torsion. Chacun de ces ressorts de torsion comporte une extrémité fixée dans le châssis 6 et une autre extrémité qui coulisse sur un méplat 60, 66 respectif. Entre ces deux extrémités, chacun de ces ressorts de torsion comporte une portion centrale enroulée autour de l'axe 10 et déplacée par l'ustensile 4 lorsque celui-ci est incliné.

En variante, le capteur de la position angulaire de l'ustensile comporte un capteur de champs magnétiques qui mesure la direction du moment magnétique de la bascule magnétique. Dans ce mode réalisation, l'aimant permanent 176 peut être omis de sorte que l'ustensile peut être totalement dépourvu de pièce magnétique.

Dans un autre mode de réalisation, les capteurs de champ magnétique sont remplacés par des capteurs mécaniques, comme des boutons, qui sont enfoncés lorsque la bascule penche d'un côté ou de l'autre. Dans ce cas aussi, l'ustensile peut être dépourvu de pièce magnétique.

En variante, la carte électronique 190 ne comporte pas le calculateur électronique mais, par exemple, seulement les capteurs de champ magnétique. Typiquement, dans ce cas, le calculateur électronique est déporté à l'extérieur de l'interface homme-machine.

En variante, l'ensemble magnétique du châssis utilisé pour générer la force de rappel de l'ustensile 4 vers sa position neutre ne permet pas de générer la force d'attraction qui maintient le point 40 et, en alternance, le point 44 dans sa position active. Par exemple, pour maintenir les points 40 et 44 dans leurs positions actives, le châssis et la bascule magnétique comportent des pièces magnétiques dédiées à cette fonction. Ces pièces magnétiques sont alors différentes de celles de l'ensemble magnétique utilisé pour générer la force de rappel. Par exemple, le châssis ou la bascule magnétique comportent des aimants permanents supplémentaires qui génèrent une force d'attraction dans une direction horizontale parallèle à la direction Y qui est apte à maintenir l'un des points d'appui de la bascule dans sa position active.

En variante, les positions inclinées à gauche et à droite ne sont pas symétriques l'une de l'autre. De même, les positions penchées à gauche et à droite de la bascule ne sont pas nécessairement symétriques l'une de l'autre.

### Chapitre III : Avantages des modes de réalisations décrits :

Le fait de générer une force de rappel à l'aide d'un aimant permanent permet de réduire l'encombrement de l'interface homme-machine par rapport à des interfaces hommes-machines identiques, mais dans lesquelles la force de rappel est générée à l'aide de ressorts tels que des ressorts hélicoïdaux.

Le fait d'utiliser une bascule magnétique indépendante de l'ustensile limite le nombre de pièces magnétiques à fixer directement sur l'ustensile. Cela simplifie donc la réalisation de l'ustensile. De plus, les tolérances sur le positionnement de l'ustensile par rapport aux châssis peuvent aussi être augmentées, car cela n'a pas d'influence notoire sur l'amplitude de la force de rappel.

Puisque les coulisseaux de la liaison glissière sont décalés par rapport à l'axe de rotation de l'ustensile, il existe un moment non nul à vaincre avant de réussir à déplacer l'ustensile vers l'une de ses positions inclinées. Grâce à cela, la sensibilité de l'interface homme-machine aux vibrations est réduite.

Le fait de maintenir les points d'appui dans leur position montée seulement à l'aide d'une force d'attraction magnétique qui s'exerce entre l'ensemble magnétique et la bascule magnétique simplifie l'architecture et le montage de l'interface homme-machine.

Le fait que la force de rappel magnétique soit générée à l'aide d'un aimant permanent et d'une pièce magnétique non aimantée de façon permanente, permet de concentrer les lignes de champ de l'aimant permanent à l'intérieur de la pièce magnétique. Cela limite donc les lignes de champ qui se rebouclent en passant en dehors de cette pièce magnétique. Le risque que les lignes de champ de cet aimant permanent puissent perturber un composant électronique situé à proximité de l'aimant permanent est donc réduit.

Le fait d'utiliser des paires d'aimants permanents disposées les uns à côté des autres, de manière à accoler chaque pôle Sud d'un aimant permanent à un pôle Nord d'un autre aimant permanent, permet d'obtenir des lignes de champs qui se rebouclent plus rapidement et qui sont donc plus courtes. Cela limite également le risque que les lignes de champ de ce groupe d'aimants permanents puissent perturber le fonctionnement de composants électroniques situés à proximité.

Le fait que les pôles magnétiques en vis-à-vis de l'ensemble magnétique et de la bascule magnétique soient de polarité opposée permet de générer une force de rappel qui décroît au fur et à mesure que l'ustensile se déplace vers l'une quelconque de ses positions inclinées.

A l'inverse, le fait que les pôles magnétiques en vis-à-vis de l'ensemble magnétique et de la bascule magnétique soient de même polarité permet de générer une force de rappel qui augmente au fur et à mesure que l'ustensile se déplace vers l'une quelconque de ses positions inclinées.

## Revendications

1. Interface homme-machine comportant :
- un châssis (6; 106; 502; 606) fixe,
- un ustensile (4; 104; 402; 604) déplaçable, par un utilisateur, en rotation dans un premier sens, autour d'un premier axe (10; 116), depuis une position neutre vers une première position inclinée, la position neutre étant la position de l'ustensile en absence de sollicitation extérieure sur cet ustensile,
- un mécanisme de rappel qui sollicite en permanence l'ustensile vers sa position neutre, ce mécanisme de rappel comportant un ensemble magnétique comportant une ou plusieurs pièces magnétiques (30, 32; 130; 410; 510) chacune fixée sur le châssis, óu
- le mécanisme de rappel comporte :
- une bascule magnétique (34; 134; 188; 204; 304; 404; 608, 610) déplaçable en rotation dans le premier sens, autour d'un deuxième axe (36, 38; 136, 138), depuis une position de repos dans laquelle elle maintient l'ustensile dans sa position neutre vers une première position penchée dans laquelle l'ustensile est dans sa première position inclinée, le deuxième axe étant distinct et parallèle au premier axe, l'un de l'ensemble magnétique et de la bascule magnétique comportant un groupe d'un ou plusieurs aimants permanents (30, 32; 130; 410; 510), ce groupe d'aimants permanents étant apte à coopérer avec l'autre de cet ensemble magnétique et de la bascule magnétique pour générer une force de rappel magnétique qui sollicite en permanence la bascule magnétique vers sa position de repos,
- une liaison glissière apte à transformer le déplacement de l'ustensile en rotation dans le premier sens, en un déplacement en rotation dans le premier sens de la bascule, cette liaison glissière comportant à cet effet :
- un premier méplat (60, 66; 160, 166) entièrement situé d'un côté d'un plan médian contenant le premier axe, et
- un premier coulisseau (62, 68; 162, 168) situé à au moins 1 mm du premier axe et apte à venir en appui sur le premier méplat pour glisser le long du premier méplat lorsque l'ustensile se déplace entre sa position neutre et sa première position inclinée,
- l'ustensile (4; 104; 402; 604) comporte l'un de ce premier coulisseau et du premier méplat et la bascule magnétique (34; 134; 204; 304; 404; 608, 610) comporte l'autre de ce premier coulisseau et du premier méplat de sorte que cette liaison glissière est apte à transformer le déplacement de l'ustensile vers la première position inclinée en un déplacement de la bascule magnétique vers sa première position penchée et à transformer le déplacement de la bascule magnétique vers sa position de repos en un déplacement de l'ustensile vers sa position neutre, où
- le châssis (6; 106; 502; 606) comporte une première butée (42, 46; 142, 146) située à l'emplacement du deuxième axe,
- la bascule magnétique comporte un premier point d'appui (40, 44; 140, 144) déplaçable entre :
- une position active dans laquelle il est en appui sur la première butée pour former, par coopération de forme avec cette première butée, une première articulation qui permet à la bascule de tourner autour du deuxième axe lorsque l'ustensile est déplacé entre sa position neutre et sa première position inclinée, et
- une position éloignée dans laquelle le premier point d'appui est éloigné de la première butée,
- le groupe d'aimants permanents (30, 32; 130; 410; 510) ou un autre groupe d'un ou plusieurs aimants permanents est apte à générer une force d'attraction magnétique qui maintient le premier point d'appui dans sa position active tant que la bascule magnétique est déplacée entre sa position neutre et sa première position penchée.

2. Interface selon la revendication 1, dans laquelle un seul de l'ensemble magnétique et de la bascule magnétique comporte le groupe d'aimants permanents (130; 410; 510), l'autre de l'ensemble magnétique et de la bascule magnétique comporte seulement un groupe d'une ou plusieurs pièces magnétiques (134; 150; 204; 608, 610) propre, par coopération avec le groupe d'aimants permanents, à générer la force de rappel magnétique.

3. Interface selon la revendication 2, dans laquelle :
- le groupe (510) d'aimants permanents comporte un pôle sud et un pôle nord directement juxtaposé l'un à l'autre, et
- le pôle sud et le pôle nord juxtaposés sont tous les deux tournés vers l'une des pièces magnétiques du groupe de pièces magnétiques.

4. Interface selon l'une quelconque des revendications précédentes, dans laquelle :
- l'ustensile comporte :
- un corps (122) monté à rotation autour du premier axe, ce corps comportant :
- celui du premier coulisseau et du premier méplat qui est compris dans l'ustensile, et
- une coulisse (170) ;
- un poussoir (120) déplaçable, par l'utilisateur, en coulissant à l'intérieur de la coulisse, entre une position relâchée et une position enfoncée,
- la bascule magnétique comporte une lame ressort (178; 204) qui exerce en permanence sur le poussoir une force qui le repousse vers sa position relâchée, l'amplitude de cette force étant inférieure à l'amplitude de la force de rappel magnétique générée lorsque la bascule magnétique est dans sa position de repos.

5. Interface selon la revendication 4, dans lequel la lame ressort (204) est réalisée dans un matériau magnétique et coopère en plus avec l'ensemble magnétique (130) du châssis pour générer la force de rappel magnétique.

6. Interface selon l'une quelconque des revendications précédentes, dans laquelle :
- l'ensemble magnétique (410) comporte un premier pôle magnétique tourné vers la bascule magnétique, et
- la bascule magnétique (404) comporte un second pôle magnétique, en vis-à-vis du premier pôle magnétique et de même polarité que le premier pôle magnétique, de sorte que les premier et second pôles se repoussent.

7. Interface selon l'une quelconque des revendications 1 à 5, dans laquelle :
- l'ensemble magnétique (130; 510) comporte un premier pôle magnétique tourné vers la bascule magnétique (134; 188; 204; 304; 608, 610), et
- la bascule magnétique (134; 188; 204; 304; 608, 610) comporte un second pôle magnétique, en vis-à-vis du premier pôle magnétique et de polarité opposée à la polarité du premier pôle magnétique, de sorte que ce second pôle magnétique est attiré par le premier pôle magnétique.

8. Interface selon l'une quelconque des revendications précédentes, dans laquelle :
- l'ustensile (4; 104; 402; 604) est déplaçable, par l'utilisateur, en rotation dans un second sens opposé au premier sens, autour du premier axe depuis la position neutre vers une seconde position inclinée,
- la bascule magnétique est déplaçable en rotation dans le second sens autour d'un troisième axe (38; 138) de rotation depuis sa position de repos vers une seconde position penchée dans laquelle l'ustensile est dans sa seconde position inclinée, le troisième axe étant distinct et parallèle au premier axe et situé, par rapport au plan médian (12), d'un côté opposé au côté où se trouve le deuxième axe (36; 136),
- la liaison glissière comporte :
- un second méplat (66; 166) entièrement situé d'un côté du plan médian opposé au côté où est situé le premier méplat (60; 160), et
- un second coulisseau (68, 168) situé à plus de 1 mm du premier axe et apte à venir en appui sur le second méplat pour glisser le long du second méplat lorsque l'ustensile se déplace entre sa position neutre et sa seconde position inclinée,
- l'ustensile comporte l'un de ce second coulisseau et du second méplat et la bascule magnétique comporte l'autre de ce second coulisseau et du second méplat de sorte que cette liaison glissière est apte à transformer le déplacement de l'ustensile vers la seconde position inclinée en un déplacement de la bascule magnétique vers sa seconde position penchée et à transformer le déplacement de la bascule magnétique depuis sa seconde position penchée vers sa position de repos en un déplacement de l'ustensile depuis sa seconde position inclinée vers sa position neutre.

9. Interface selon la revendication 8, dans lequel :
- le châssis comporte une seconde butée (46; 146) située à l'emplacement du troisième axes,
- la bascule magnétique comporte un second point d'appui (44; 164) déplaçable entre :
- une position active dans laquelle il est en appui sur la seconde butée pour former, par coopération de forme avec cette seconde butée, une seconde articulation qui permet à la bascule magnétique de tourner autour du troisième axe (38; 138) lorsque l'ustensile est déplacé depuis sa position neutre vers sa seconde position inclinée, et
- une position éloignée dans laquelle le second point d'appui est éloigné de la seconde butée lorsque l'ustensile est déplacé depuis sa position neutre vers sa première position inclinée,
- le groupe d'aimants permanents (30, 32; 130; 410; 510; 608, 610) ou un autre groupe d'un ou plusieurs aimants permanents est apte à générer une force d'attraction magnétique qui maintient le second point d'appui dans sa position active tant que la bascule magnétique est déplacée entre sa position neutre et sa seconde position penchée.

10. Interface selon l'une quelconque des revendications précédentes, dans laquelle la distance entre le premier axe et le premier coulisseau est supérieure à 3 mm.

11. Interface selon l'une quelconque des revendications précédentes, dans laquelle l'ustensile est uniquement déplaçable en rotation autour d'un ou plusieurs axes qui passent tous par un même point fixe par rapport au châssis.

12. Interface selon l'une quelconque des revendications précédentes, dans laquelle, en absence de sollicitation extérieure, la force de rappel magnétique suffit à elle-seule pour ramener l'ustensile depuis sa première position inclinée jusqu'à sa position neutre.

## Patentansprüche

1. Mensch-Maschine-Schnittstelle bestehend aus :
- ein feststehendes Gestell (6; 106; 502; 606),
- ein Utensil (4; 104; 402; 604), das von einem Benutzer in einer ersten Richtung um eine erste Achse (10; 116) aus einer neutralen Position in eine erste geneigte Position gedreht werden kann, wobei die neutrale Position die Position des Utensils ist, in der keine äußere Belastung auf das Utensil einwirkt,
- einen Rückholmechanismus, der das Utensil permanent in seine neutrale Position drückt, wobei dieser Rückholmechanismus eine magnetische Baugruppe mit einem oder mehreren magnetischen Teilen (30, 32; 130; 410; 510) umfasst, die jeweils an dem Rahmen befestigt sind,
wobei:
- der Rückholmechanismus umfasst:
- eine magnetische Wippe (34; 134; 188; 204; 304; 404; 608, 610), die in der ersten Richtung um eine zweite Achse (36, 38; 136, 138) aus einer Ruheposition, in der sie das Utensil in seiner neutralen Position hält, in eine erste geneigte Position, in der sich das Utensil in seiner ersten geneigten Position befindet, wobei die zweite Achse von der ersten Achse getrennt und parallel zu dieser ist, wobei entweder die Magnetanordnung oder die Magnetwippe eine Gruppe von einem oder mehreren Permanentmagneten (30, 32; 130; 410; 510) , wobei diese Gruppe von Permanentmagneten mit der anderen der magnetischen Anordnung und der magnetischen Wippe zusammenwirken kann, um eine magnetische Rückstellkraft zu erzeugen, die die magnetische Wippe ständig in Richtung ihrer Ruheposition vorspannt,
- eine Gleitverbindung, die geeignet ist, die Drehbewegung des Utensils in der ersten Richtung in eine Drehbewegung der Wippe in der ersten Richtung umzuwandeln, wobei diese Gleitverbindung zu diesem Zweck umfasst:
- eine erste Abflachung (60, 66; 160, 166), die sich vollständig auf einer Seite einer die erste Achse enthaltenden Mittelebene befindet, und
- einen ersten Schieber (62, 68; 162, 168), der sich mindestens 1 mm von der ersten Achse entfernt befindet und an der ersten Abflachung anliegen kann, um entlang der ersten Abflachung zu gleiten, wenn sich das Utensil zwischen seiner neutralen Position und seiner ersten geneigten Position bewegt,
- das Utensil (4; 104; 402; 604) den ersten Schieber oder die erste Abflachung aufweist und die magnetische Wippe (34; 134; 204; 304; 404; 608, 610) den anderen des ersten Schiebers und der ersten Abflachung aufweist, so dass diese Gleitverbindung geeignet ist, die Bewegung des Utensils in die erste geneigte Position in eine Bewegung der magnetischen Wippe in ihre erste geneigte Position umzuwandeln und die Bewegung der magnetischen Wippe in ihre Ruheposition in eine Bewegung des Utensils in seine neutrale Position umzuwandeln ,
wobei:
- der Rahmen (6; 106; 502; 606) einen ersten Anschlag (42, 46; 142, 146) aufweist, der sich an der Stelle der zweiten Achse befindet,
- die Magnetwippe einen ersten Stützpunkt (40, 44; 140, 144) aufweist, der verschiebbar ist zwischen :
- eine aktive Position, in der es an dem ersten Anschlag anliegt, um durch Formschluss mit diesem ersten Anschlag ein erstes Gelenk zu bilden, das es der Wippe ermöglicht, sich um die zweite Achse zu drehen, wenn das Utensil zwischen seiner neutralen Position und seiner ersten geneigten Position bewegt wird, und
- eine entfernte Position, in der der erste Stützpunkt vom ersten Anschlag entfernt ist,
- die Gruppe von Permanentmagneten (30, 32; 130; 410; 510) oder eine andere Gruppe von einem oder mehreren Permanentmagneten dazu geeignet ist, eine magnetische Anziehungskraft zu erzeugen, die den ersten Stützpunkt in seiner aktiven Position hält, solange die magnetische Wippe zwischen ihrer neutralen Position und ihrer ersten geneigten Position bewegt wird.

2. Schnittstelle nach Anspruch 1, wobei nur eine der magnetischen Baugruppe und der magnetischen Wippe die Gruppe von Permanentmagneten (130; 410; 510) umfasst, die andere der magnetischen Baugruppe und der magnetischen Wippe nur eine Gruppe von einem oder mehreren magnetischen Teilen (134; 150; 204; 608, 610) umfasst, die durch Zusammenwirken mit der Gruppe von Permanentmagneten die magnetische Rückstellkraft erzeugen können.

3. Schnittstelle nach Anspruch 2, wobei:
- die Permanentmagnetgruppe (510) einen Südpol und einen Nordpol aufweist, die direkt nebeneinander liegen, und
- der nebeneinander liegende Süd- und Nordpol beide auf eine der magnetischen Münzen in der Gruppe der magnetischen Münzen gerichtet sind.

4. Schnittstelle nach einem der vorhergehenden Ansprüche, wobei:
- das Utensil umfasst:
- einen Körper (122), der um die erste Achse drehbar angebracht ist, wobei dieser Körper umfasst:
- dasjenige des ersten Schiebers und der ersten Abflachung, das in dem Utensil enthalten ist, und
- eine Kulisse (170) ;
- einen Drücker (120), der vom Benutzer durch Gleiten innerhalb des Schiebers zwischen einer losgelassenen und einer gedrückten Position bewegt werden kann,
- die magnetische Wippe eine Blattfeder (178; 204) umfasst, die ständig eine Kraft auf den Drücker ausübt, die ihn in seine gelöste Position drückt, wobei die Amplitude dieser Kraft kleiner ist als die Amplitude der magnetischen Rückstellkraft, die erzeugt wird, wenn sich die magnetische Wippe in ihrer Ruheposition befindet.

5. Schnittstelle nach Anspruch 4, wobei die Blattfeder (204) aus einem magnetischen Material besteht und zusätzlich mit der magnetischen Anordnung (130) des Rahmens zusammenwirkt, um die magnetische Rückstellkraft zu erzeugen.

6. Schnittstelle nach einem der vorhergehenden Ansprüche, wobei:
- die Magnetanordnung (410) einen ersten Magnetpol hat, der der magnetischen Wippe zugewandt ist, und
- die magnetische Wippe (404) einen zweiten magnetischen Pol aufweist, der dem ersten magnetischen Pol gegenüberliegt und die gleiche Polarität wie der erste magnetische Pol hat, so dass sich der erste und der zweite Pol abstoßen.

7. Schnittstelle nach einem der Ansprüche 1 bis 5, wobei:
- die Magnetanordnung (130; 510) einen ersten Magnetpol aufweist, der der Magnetwippe (134; 188; 204; 304; 608, 610) zugewandt ist, und
- die magnetische Wippe (134; 188; 204; 304; 608, 610) einen zweiten magnetischen Pol aufweist, der dem ersten magnetischen Pol gegenüberliegt und eine Polarität aufweist, die der Polarität des ersten magnetischen Pols entgegengesetzt ist, so dass der zweite magnetische Pol von dem ersten magnetischen Pol angezogen wird.

8. Schnittstelle nach einem der vorhergehenden Ansprüche, wobei:
- das Utensil (4; 104; 402; 604) durch den Benutzer in einer zweiten, der ersten Richtung entgegengesetzten Richtung um die erste Achse aus der neutralen Position in eine zweite, geneigte Position drehbar beweglich ist,
- die magnetische Wippe in der zweiten Richtung um eine dritte Drehachse (38; 138) aus ihrer Ruheposition in eine zweite geneigte Position drehbar ist, in der sich das Utensil in seiner zweiten geneigten Position befindet, wobei die dritte Achse von der ersten Achse verschieden und parallel zu dieser ist und sich in Bezug auf die Mittelebene (12) auf einer Seite befindet, die der Seite gegenüberliegt, auf der sich die zweite Achse (36; 136) befindet,
- die Gleitverbindung umfasst:
- eine zweite Abflachung (66; 166), die sich vollständig auf einer Seite der Mittelebene gegenüber der Seite befindet, auf der sich die erste Abflachung (60; 160) befindet, und
- einen zweiten Schieber (68, 168), der mehr als 1 mm von der ersten Achse entfernt ist und sich an der zweiten Abflachung abstützen kann, um entlang der zweiten Abflachung zu gleiten, wenn sich das Utensil zwischen seiner neutralen Position und seiner zweiten geneigten Position bewegt,
- das Utensil einen des zweiten Schiebers und der zweiten Abflachung aufweist und die Magnetwippe den anderen des zweiten Schiebers und der zweiten Abflachung aufweist, so dass diese Gleitverbindung geeignet ist, die Bewegung des Utensils in die zweite geneigte Position in eine Bewegung der Magnetwippe in ihre zweite geneigte Position umzuwandeln und die Bewegung der Magnetwippe von ihrer zweiten geneigten Position in ihre Ruheposition in eine Bewegung des Utensils von seiner zweiten geneigten Position in seine neutrale Position umzuwandeln.

9. Schnittstelle nach Anspruch 8, wobei:
- der Rahmen einen zweiten Anschlag (46; 146) aufweist, der sich an der Stelle des dritten Stifts befindet,
- die Magnetwippe einen zweiten Stützpunkt (44; 164) aufweist, der verschiebbar ist zwischen :
- eine aktive Position, in der sie an dem zweiten Anschlag anliegt, um durch Formschluss mit diesem zweiten Anschlag ein zweites Gelenk zu bilden, das es der Magnetwippe ermöglicht, sich um die dritte Achse (38; 138) zu drehen, wenn das Utensil aus seiner neutralen Position in seine zweite geneigte Position bewegt wird, und
- eine entfernte Position, in der der zweite Stützpunkt von dem zweiten Anschlag entfernt ist, wenn das Utensil aus seiner neutralen Position in seine erste geneigte Position bewegt wird,
- die Gruppe von Permanentmagneten (30, 32; 130; 410; 510; 608, 610) oder eine andere Gruppe von einem oder mehreren Permanentmagneten dazu geeignet ist, eine magnetische Anziehungskraft zu erzeugen, die den zweiten Stützpunkt in seiner aktiven Position hält, solange die magnetische Wippe zwischen ihrer neutralen Position und ihrer zweiten geneigten Position bewegt wird.

10. Schnittstelle nach einem der vorhergehenden Ansprüche, wobei der Abstand zwischen der ersten Achse und dem ersten Schieber größer als 3 mm ist.

11. Schnittstelle nach einem der vorhergehenden Ansprüche, wobei das Utensil nur um eine oder mehrere Achsen drehbar ist, die alle durch denselben Fixpunkt in Bezug auf das Gestell verlaufen.

12. Schnittstelle nach einem der vorhergehenden Ansprüche, bei der bei fehlender äußerer Belastung die magnetische Rückstellkraft allein ausreicht, um das Utensil aus seiner ersten geneigten Position in seine neutrale Position zu bringen.

## Claims

1. Human-machine interface comprising :
- a fixed frame (6; 106; 502; 606),
- a utensil (4; 104; 402; 604) movable by a user in rotation in a first direction, about a first axis (10; 116), from a neutral position to a first inclined position, the neutral position being the position of the utensil in the absence of external stress on this utensil,
- a return mechanism which permanently urges the utensil towards its neutral position, this return mechanism comprising a magnetic assembly comprising one or more magnetic parts (30, 32; 130; 410; 510) each fixed to the frame,
where :
- the return mechanism comprises :
- a magnetic rocker (34; 134; 188; 204; 304; 404; 608, 610) rotatable in the first direction, about a second axis (36, 38; 136, 138), from a rest position in which it holds the utensil in its neutral position to a first tilted position in which the utensil is in its first tilted position, the second axis being distinct from and parallel to the first axis, one of the magnetic assembly and the magnetic rocker comprising a group of one or more permanent magnets (30, 32; 130; 410; 510) , this group of permanent magnets being able to cooperate with the other of this magnetic assembly and the magnetic rocker to generate a magnetic restoring force which permanently urges the magnetic rocker towards its rest position,
- a sliding link capable of transforming the rotational movement of the utensil in the first direction into a rotational movement of the rocker in the first direction, this sliding link comprising for this purpose :
- a first flat (60, 66; 160, 166) located entirely on one side of a median plane containing the first axis, and
- a first slider (62, 68; 162, 168) located at least 1 mm from the first axis and capable of bearing on the first flat surface to slide along the first flat surface when the utensil moves between its neutral position and its first inclined position,
- the utensil (4; 104; 402; 604) comprises one of this first slide and the first flat and the magnetic rocker (34; 134; 204; 304; 404; 608, 610) comprises the other of this first slide and the first flat so that this sliding connection is able to transform the movement of the utensil towards the first inclined position into a movement of the magnetic rocker towards its first tilted position and to transform the movement of the magnetic rocker towards its rest position into a movement of the utensil towards its neutral position ,
where :
- the frame (6; 106; 502; 606) comprises a first stop (42, 46; 142, 146) located at the location of the second axis,
- the magnetic rocker comprises a first support point (40, 44; 140, 144) which can be moved between :
- an active position in which it rests on the first stop to form, by cooperation of shape with this first stop, a first articulation which allows the rocker to rotate about the second axis when the utensil is moved between its neutral position and its first inclined position, and
- a remote position in which the first support point is away from the first stop,
- the group of permanent magnets (30, 32; 130; 410; 510) or another group of one or more permanent magnets is able to generate a magnetic attraction force which maintains the first support point in its active position as long as the magnetic rocker is moved between its neutral position and its first tilted position.

2. An interface according to claim 1, wherein only one of the magnetic assembly and the magnetic rocker comprises the group of permanent magnets (130; 410; 510), the other of the magnetic assembly and the magnetic rocker comprises only a group of one or more magnetic parts (134; 150; 204; 608, 610) adapted, by co-operation with the group of permanent magnets, to generate the magnetic restoring force.

3. The interface of claim 2, wherein :
- the group (510) of permanent magnets has a south pole and a north pole directly juxtaposed to each other, and
- the juxtaposed south pole and north pole both face one of the magnetic parts in the group of magnetic parts.

4. An interface according to any one of the preceding claims, wherein :
- the utensil comprises :
- a body (122) mounted so as to rotate about the first axis, this body comprising :
- that of the first slide and the first flat which are included in the utensil, and
- a slide (170);
- a pusher (120) which can be moved by the user, by sliding inside the slide, between a released position and a depressed position,
- the magnetic rocker comprises a leaf spring (178; 204) which permanently exerts a force on the plunger which pushes it back towards its released position, the amplitude of this force being less than the amplitude of the magnetic return force generated when the magnetic rocker is in its rest position.

5. An interface as claimed in claim 4, wherein the leaf spring (204) is made of a magnetic material and additionally co-operates with the magnet assembly (130) of the chassis to generate the magnetic restoring force.

6. An interface according to any one of the preceding claims, wherein :
- the magnet assembly (410) has a first magnetic pole facing the magnet rocker, and
- the magnetic flip-flop (404) has a second magnetic pole, opposite the first magnetic pole and of the same polarity as the first magnetic pole, so that the first and second poles repel each other.

7. An interface according to any one of claims 1 to 5, wherein :
- the magnet assembly (130; 510) has a first magnetic pole facing the magnetic flip-flop (134; 188; 204; 304; 608, 610), and
- the magnetic flip-flop (134; 188; 204; 304; 608, 610) comprises a second magnetic pole, opposite the first magnetic pole and of opposite polarity to the first magnetic pole, so that this second magnetic pole is attracted by the first magnetic pole.

8. An interface according to any one of the preceding claims, wherein :
- the utensil (4; 104; 402; 604) can be rotated by the user in a second direction, opposite to the first direction, about the first axis from the neutral position to a second inclined position,
- the magnetic rocker is rotatable in the second direction about a third axis (38; 138) of rotation from its rest position to a second tilted position in which the utensil is in its second tilted position, the third axis being distinct from and parallel to the first axis and located, with respect to the median plane (12), on a side opposite the side on which the second axis (36; 136) is located,
- the sliding connection comprises :
- a second flat (66; 166) located entirely on one side of the median plane opposite the side on which the first flat (60; 160) is located, and
- a second slide (68, 168) located more than 1 mm from the first axis and able to come to rest on the second flat so as to slide along the second flat when the utensil moves between its neutral position and its second inclined position,
- the utensil comprises one of this second slide and the second flat and the magnetic rocker comprises the other of this second slide and the second flat so that this sliding connection is able to transform the movement of the utensil towards the second inclined position into a movement of the magnetic rocker towards its second inclined position and to transform the movement of the magnetic rocker from its second inclined position towards its rest position into a movement of the utensil from its second inclined position towards its neutral position.

9. The interface of claim 8, wherein :
- the frame has a second stop (46; 146) located at the location of the third pin,
- the magnetic rocker comprises a second support point (44; 164) movable between :
- an active position in which it rests on the second stop to form, by cooperation of shape with this second stop, a second articulation which enables the magnetic rocker to rotate about the third axis (38; 138) when the utensil is moved from its neutral position to its second inclined position, and
- a remote position in which the second support point is moved away from the second stop when the utensil is moved from its neutral position to its first inclined position,
- the group of permanent magnets (30, 32; 130; 410; 510; 608, 610) or another group of one or more permanent magnets is able to generate a magnetic attraction force which maintains the second support point in its active position as long as the magnetic rocker is moved between its neutral position and its second tilted position.

10. Interface according to any of the preceding claims, wherein the distance between the first axis and the first slide is greater than 3 mm.

11. Interface according to any one of the preceding claims, in which the utensil can only be moved in rotation about one or more axes which all pass through the same fixed point relative to the chassis.

12. Interface according to any one of the preceding claims, in which, in the absence of external stress, the magnetic return force alone is sufficient to return the utensil from its first inclined position to its neutral position.
